# EUROPEAN PATENT SPECIFICATION

(11) **EP 4 660 580 B1**
(45) Date of publication and mention of the grant of the patent: **11.11.2026**
(21) Application number: 25178450.0
(22) Date of filing: 23.05.2025
(51) Int. Cl.: G01C 19/5726, G01C 19/5762

(54) **GYROSCOPE ROTOR VOLTAGE HOLDING CIRCUIT FOR UNEXPECTED POWER SUPPLY REMOVAL**
GYROSKOPROTORSPANNUNGSHALTESCHALTUNG ZUR UNERWARTETEN STROMVERSORGUNGSENTFERNUNG
CIRCUIT DE MAINTIEN DE TENSION DE ROTOR DE GYROSCOPE POUR UNE SUPPRESSION D'ALIMENTATION ÉLECTRIQUE INATTENDUE

(30) Priority: 07.06.2024 US 202418737073
(43) Date of publication of application: 10.12.2025
(73) Proprietor: STMicroelectronics International N.V., 1228 Plan-les-Ouates, Geneva (CH)
(72) Inventor: TARSI, Riccardo, 20006 PREGNANA MILANESE (MI) (IT); LAVELLI, Emanuele, 23826 MANDELLO DEL LARIO (LC) (IT); GIANCRISTOFARO, Lorenzo, 20142 MILANO (IT)
(74) Representative: Studio Torta S.p.A.

(56) References cited:
- US-A1- 2019 072 389
- US-A1- 2019 145 773
- US-A1- 2020 150 144
- US-B1- 6 296 779

## Description

### TECHNICAL FIELD

The present invention relates to the field of Micro-Electro-Mechanical Systems (MEMS) gyroscopes and, in particular, to circuitry and an associated control method for operation with an inverted mismatch where the drive resonance frequency is higher than the sense resonance frequency, yet that avoids a mode-matched condition where the sense and drive resonance frequencies align due to a power-down event or an interruption in the power supply.

### BACKGROUND

Micro-Electro-Mechanical Systems (MEMS) gyroscopes are commonly utilized in consumer electronics to measure angular velocities. A MEMS gyroscope is formed by a microscale stator and two mechanically coupled movable masses. These masses are granted a relative degree of freedom with respect to the stator and each other.

One of the movable masses, referred to as the driving mass, is dedicated to driving and is maintained in a state of oscillation at a resonant frequency. The other movable mass, referred to as the sensing mass, is drawn into a corresponding oscillatory motion as a result of its mechanical coupling to the driving mass, when an external rate is applied or even in the presence of mechanical quadrature. When the microstructure of the gyroscope is rotated about a predetermined gyroscopic axis, the sensing mass experiences a Coriolis force that is directly proportional to the applied angular velocity.

Driving circuitry maintains the driving mass in resonant oscillation with a constant amplitude by providing a driving signal thereto. Additionally, sensing circuitry detects the displacements of the sensing mass relative to the stator. These displacements are indicative of the Coriolis force and, by extension, the angular velocity. They are detected through changes in electrical signals measured by the sensing circuitry that correlate to the variations in capacitances between the sensing mass and the stator.

The rotor voltage - the voltage of the signal applied to the movable mass - influences the mechanical rigidity, or total stiffness (ktot), of the gyroscope's sense structure. This, in turn, affects the natural vibration frequency of the sensing mass, known as the sense resonance frequency (fs). When the rotor voltage is high, it induces an electrostatic softening effect on the system's stiffness. This softening decreases the sense resonance frequency, increasing the distance between the drive resonance frequency and the sense resonance frequency. In contrast, lowering the rotor voltage causes the system to become more rigid - a hardening effect - resulting in an increase in the sense resonance frequency.

Document US 2019/145773 A1 discloses a MEMS gyroscope that applies a DC bias voltage to the rotor in order to control the resonance frequency.

Frequency mismatch (Δfds) is the difference between the drive mass's natural oscillation frequency, known as the drive resonance frequency (fdr), and the sense resonance frequency (fs). The gyroscope's sensitivity, which is its ability to detect and measure angular velocity, is greater when this frequency mismatch is minimized. A lower frequency mismatch results in higher mechanical sensitivity.

High sensitivity is desired for distinguishing the desired rotational signal (indicative of angular velocity) from random electrical fluctuations, known as noise. To enhance the gyroscope's responsiveness to Coriolis input forces, known as electrical sensitivity, the rotor voltage is to be kept at a relatively high level, such as above 10V. This improves the electrical output in response to the Coriolis force, aiding in precise rotation detection. Generally speaking, a condition of non-inverted mismatch exists when the drive resonance frequency (fdr) is lower than the sense resonance frequency (fs), while a condition of an inverted mismatch exists when the drive resonance frequency (fdr) is higher than the sense resonance frequency (fs).

However, it is desired for the gyroscope's sensitivity to remain consistent over time, despite the potential stresses of soldering during assembly and the natural wear of components with age, and an inverted mismatch has been found to provide for more robust consistency of the gyroscope's sensitivity.

Utilizing an inverted mismatch does present engineering challenges. MEMS gyroscopes usually have the sense frame built with parallel plate topology to maximize sensitivity and the drive frame built with comb finger topology to maximize linearity and high range of motion. When the rotor voltage drops, as in a power-down event or during an interruption in the power supply, the sense stiffness increases, leading to a rise in the sense resonance frequency while the drive frequency remains unchanged. This decrease in frequency mismatch could lead to a mode-matched condition where the sense and drive resonance frequencies align and the mechanical output of the sense frame is maximized.

If the driving circuitry powers down, control over the oscillatory drive mass amplitude is lost, resulting in its decay, determined by the drive frame quality factor (Q factor) and frequency - typically within about 500 milliseconds.

In this condition of maximized mechanical output of the sense frame, if the oscillation amplitude of the driving mass does not diminish quickly enough, the residual movement, together with any inherent quadrature error, may prompt excessive oscillation of the sensing mass. In certain cases, this might be enough to make the sensing mass strike the internal mechanical stops, or bumpers, leading to potential damage or reliability concerns. Such collisions can release debris, forming conductive paths that risk electrical shorts between the rotor and stator.

The known approach utilized for mitigating the risks associated with an inverted mismatch involves a deliberate delay prior to reducing the rotor voltage following a power-down command (a controlled power-down of the system). This waiting period allows the driving mass oscillation to diminish to a level where, even if a mode-matched condition is inadvertently reached at power down, it no longer poses a risk of causing internal collisions or other damage within the gyroscope. However, this strategy is not foolproof.

Indeed, a drawback of this solution is its inability to cope with unexpected removals of the voltage supply, which are not preceded by a power-down command. In such scenarios, the rotor voltage would rapidly fall to zero. This sudden voltage drop could precipitate a mode-matched condition before the driving mass oscillation has sufficiently decreased, potentially resulting in the excessive oscillation of the sensing mass and the associated reliability issues previously discussed. Such a rapid transition to a mode-matched condition without the decay of the driving mass oscillation exposes the device to the very risks the delayed voltage reduction aims to prevent.

An aim of the invention is thus to solve prior art drawbacks.

### SUMMARY

According to the present invention, there are provided a MEMS gyroscope system, and a method of operating a micro-electromechanical (MEMS) gyroscope as defined in the annexed claims.

The present invention is summarized hereunder.

The MEMS gyroscope includes a driving mass flexibly mechanically coupled to a sensing mass, and stators that remain static with respect to the driving mass and the sensing mass. A driving circuitry is configured to apply a time-varying forcing signal to the driving mass through at least one capacitive coupling thereto. A charge pump is powered by a supply voltage and configured to generate a charge pump output signal. A decoupling capacitance is directly electrically connected to a rotor pad. A detecting circuitry is configured to assert a control signal when the supply voltage is greater than a threshold voltage, but to deassert the control signal when the supply voltage is less than the threshold voltage. A switch circuitry is configured to couple the charge pump output signal to the decoupling capacitance so that a DC bias voltage is formed across the decoupling capacitance when the control signal is asserted, but to decouple the charge pump output signal from the decoupling capacitance when the control signal is deasserted, such that the DC bias voltage remains constant when the time-varying forcing signal decays due to reduction in the supply voltage.

Thereby a condition is avoided where resonance frequencies of the driving mass and the sensing mass become within a threshold value of each other.

The remaining of the DC bias voltage constant while the time-varying forcing signal decays may preserve an electrostatic stiffness of the gyroscope, thereby maintaining the resonance frequency of the sensing mass relatively constant and lower than the resonance frequency of the driving mass.

According to an example, the sensing circuitry includes a voltage divider configured to generate a divided version of the supply voltage, and a comparator configured to compare the divided version of the supply voltage to a reference voltage to generate the control signal as being asserted when the divided version of the supply voltage is greater than the reference voltage but to generate the control signal as being deasserted when the divided version of the supply voltage is less than the reference voltage.

In another example, the reference voltage is generated by a bandgap voltage generator.

In another example, the stators include at least one signal sensing stator capacitively coupled to the sensing mass, with the capacitive coupling between the at least one signal sensing stator and the sensing mass changing as the sensing mass oscillates due to a Coriolis force induced by an angular rotation rate experienced by the MEMS gyroscope.

In another example, the sense readout circuitry is configured to determine the angular rotation rate based on the changes in capacitive coupling between the at least one signal sensing stator and the sensing mass.

In another example the stators include first and second forcing stators capacitively coupled to the driving mass. The time-varying forcing signal includes first and second differential forcing signals applied to the driving mass through the first and second forcing stators.

In another example the stators include feedback sensing stators capacitively coupled to the driving mass. The capacitive coupling between the feedback sensing stators and the driving mass changes as the driving mass oscillates. The driving circuitry includes a charge-to-voltage amplifier (C2V) configured to generate a feedback signal based on changes in capacitive coupling between the feedback sensing stators and the driving mass. A phase-locked loop (PLL) is configured to adjust frequency and phase of the first and second differential forcing signals based on the feedback signal.

In another example, the MEMS gyroscope is designed to operate in an inverted mismatch condition, where a resonance frequency of the driving mass is higher than a resonance frequency of the sensing mass.

In another example, the decoupling capacitor is a parasitic capacitance between the rotor pad and ground.

Also disclosed herein is a method of operating a micro-electromechanical (MEMS) gyroscope, including steps of: applying a time-varying forcing signal to a driving mass of the MEMS gyroscope through at least one capacitive coupling, wherein the driving mass is flexibly mechanically coupled to a sensing mass, and stators remain static with respect to the driving mass and the sensing mass; generating a charge pump output signal using a charge pump powered by a supply voltage; asserting a control signal when the supply voltage is greater than a threshold voltage and the MEMS gyroscope is set in a powered-on condition; deasserting the control signal when the supply voltage is less than the threshold voltage or a power down command is sent to the system to turn it off; coupling the charge pump output signal to a decoupling capacitance that is directly electrically connected to the driving mass so that a DC bias voltage is formed across the decoupling capacitance when the control signal is asserted; and decoupling the charge pump output signal from the decoupling capacitance when the control signal is deasserted.

In an example, the decoupling of the charge pump output signal from the decoupling capacitance when the control signal is deasserted causes the DC bias voltage to remain constant when the time-varying forcing signal decays due to reduction in the supply voltage, thereby avoiding a condition where resonance frequencies of the driving mass and the sensing mass become within a threshold value of each other.

The remaining of the DC bias voltage constant while the time-varying forcing signal decays preserves an electrostatic stiffness of the gyroscope, thereby maintaining the resonance frequency of the sense mass relatively constant and lower than the resonance frequency of the driving mass.

In another example, the method further includes: generating a divided version of the supply voltage using a voltage divider; and comparing the divided version of the supply voltage to a reference voltage using a comparator to generate the control signal as being asserted when the divided version of the supply voltage is greater than the reference voltage but to generate the control signal as being deasserted when the divided version of the supply voltage is less than the reference voltage.

In another example the reference voltage is generated by a bandgap voltage generator.

In another example the method further includes: detecting changes in capacitive coupling between at least one signal sensing stator and the sensing mass, wherein the capacitive coupling changes as the sensing mass oscillates due to a Coriolis force induced by an angular rotation rate experienced by the MEMS gyroscope; and determining the angular rotation rate based on the changes in capacitive coupling between the at least one signal sensing stator and the sensing mass.

In another example, applying the time-varying forcing signal includes: generating a single-ended forcing signal using a phase-locked loop (PLL); generating a first differential forcing signal from the single-ended forcing signal using a non-inverting amplifier; generating a second differential forcing signal from the single-ended forcing signal using an inverting amplifier, wherein the first and second differential forcing signals are complementary signals with a same amplitude but opposite in phase; and applying the first and second differential forcing signals to the driving mass through first and second forcing stators of the stators that are capacitively coupled to the driving mass.

In another example, the method further includes: generating a feedback signal based on changes in capacitive coupling between feedback sensing stators and the driving mass, wherein the capacitive coupling changes as the driving mass oscillates; and adjusting frequency and phase of the single-ended forcing signal based on the feedback signal using the PLL.

### BRIEF DESCRIPTION OF THE DRAWINGS

FIG. 1 is a block diagram of a MEMS gyroscope system disclosed herein.
FIG. 2 is a graph showing voltages of the MEMS gyroscope system of FIG. 1 during a power supply interruption event.
FIG. 3 is a graph showing voltages of the MEMS gyroscope system of FIG. 1 during power-down.

### DETAILED DESCRIPTION

Note that in the following description, any resistor or resistance mentioned is a discrete device, unless stated otherwise, and is not simply an electrical lead between two points. Therefore, any resistor or resistance connected between two points has a higher resistance than a lead between those two points, and such resistor or resistance cannot be interpreted as a lead. Similarly, any capacitor or capacitance mentioned is a discrete device, unless stated otherwise, and is not a parasitic element, unless stated otherwise. Additionally, any inductor or inductance mentioned is a discrete device, unless stated otherwise, and is not a parasitic element, unless stated otherwise.

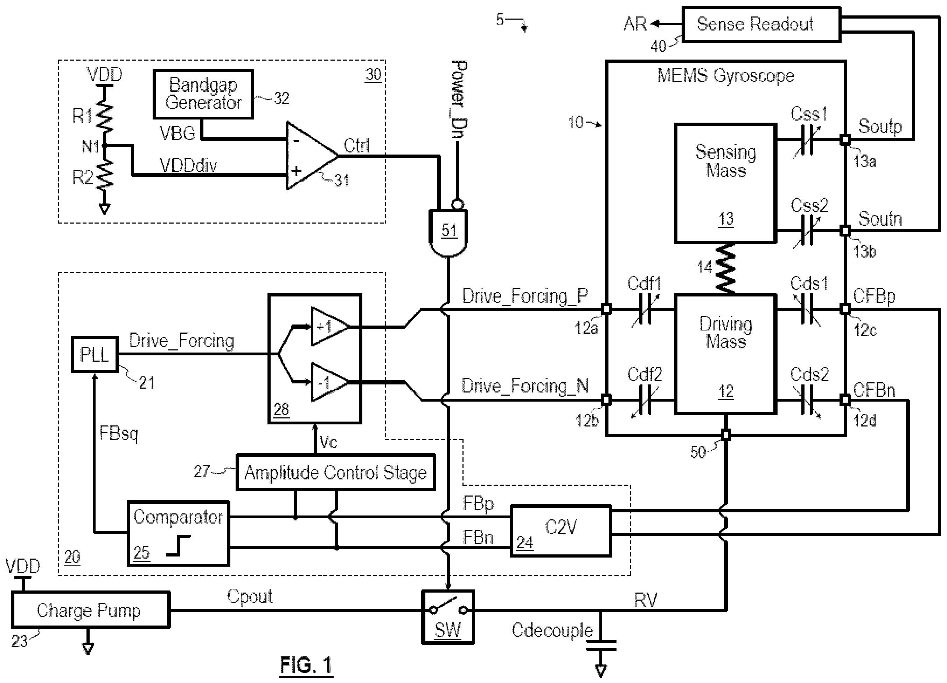

Now described with reference to FIG. 1 is a MEMS gyroscope system 5, including a MEMS gyroscope 10 and its associated driving and readout circuitry.

The MEMS gyroscope 10 includes a driving mass 12 mechanically connected to a sensing mass 13 through a suspension system (flexures 14), which allows them to oscillate perpendicularly to each other.

The MEMS gyroscope 10 includes driving stators 12a and 12b that are capacitively coupled to the driving mass 12 via respective comb-finger arrangements, and feedback sensing stators 12c and 12d that are also capacitively coupled to the driving mass 12 via respective comb-finger arrangements. In greater detail, the capacitive coupling between the driving stator 12a and the driving mass 12 forms a first driving capacitance Cdf1, the capacitive coupling between the driving stator 12b and the driving mass 12 forms a second driving capacitance Cdf2, the capacitive coupling between the feedback sensing stator 12c and the driving mass 12 forms a first feedback capacitance Cds1, and the capacitive coupling between the feedback sensing stator 12d and the driving mass 12 forms a second feedback capacitance Cds2.

A rotor pad 50 provides for connection of a DC rotor voltage RV to the driving mass 12 to establish a potential difference between the driving mass 12 and the driving stators 12a, 12b, 12c, and 12d. The capacitive couplings Cdf1 and Cdf2 between the driving stators 12a and 12b and the driving mass 12 are used to apply a differential driving signal, Drive_Forcing_P and Drive_Forcing_N, which, in combination with the DC rotor voltage RV, generates the electrostatic force that drives the oscillation of the driving mass 12. The DC rotor voltage RV provides a constant bias voltage that enhances the electrostatic force generated by the differential driving signals.

The differential driving signals Drive_Forcing_P and Drive_Forcing_N are generated by the driving circuitry 20. Included in the driving circuitry 20 is a phase-locked loop (PLL) 21, which generates a single-ended square-wave driving signal Drive_Forcing.

As the driving mass 12 oscillates, the capacitances Cds1 and Cds2 between the comb fingers of the feedback sensing stators 12c and 12d and the driving mass 12 change. These movement-based capacitance modulations are used for sensing the oscillation amplitude and phase of the driving mass 12, and are provided as differential feedback charge signals CFBp and CFBn to the driving circuitry 20. In the driving circuitry 20, a charge sensitive circuit 24, in particular a C2V (charge-to-voltage amplifier) 24, receives the differential feedback charge signals CFBp and CFBn, and generates fully differential feedback signals FBp and FBn therefrom. These feedback signals FBp and FBn are then used by a comparator 25 to generate and feed to the PLL 21 a square wave FBsq that is in phase with drive mass movement.

The PLL 21 makes use of the square wave FBsq to adjust frequency and phase of its output Drive_Forcing accordingly. In the meanwhile, the amplitude information of feedback signals FBp and FBm is extrapolated by an amplitude control stage 27 and a control voltage Vc is generated to control the drive mass oscillation amplitude. The amplitude control voltage Vc and the Drive_Forcing signal produced by the PLL are combined to produce the forcing signals Drive_Forcing_P and Drive_Forcing_N by a single-ended to fully-differential actuation stage 28.

This closed-loop feedback system maintains a stable oscillation, in terms of amplitude, phase and frequency, of the driving mass 12, even in the presence of environmental changes or variations in the MEMS gyroscope's parameters.

Among the stators are the sensing stators 13a and 13b, which are capacitively coupled to the sensing mass 13. In greater detail, the capacitive coupling between the sensing mass 13 and the signal sensing stator 13a forms a first sensing capacitance Css1, and the capacitive coupling between the sensing mass 13 and the signal sensing stator 13b forms a second sensing capacitance Css2. These capacitive couplings, Css1 and Css2, between the sensing mass 13 and the signal sensing stator 13a and 13b, are used to detect the Coriolis-induced oscillation of the sensing mass 13, which is proportional to the angular rate experienced by the MEMS gyroscope.

In the absence of rotation, the sensing mass 13 oscillates with a fixed relationship to the driving mass 12 due to their mechanical coupling, also known as quadrature. When the gyroscope is subjected to an angular rotation rate about an axis perpendicular to the drive axis and the sense axis, the Coriolis force acts on the sensing mass 13. This force causes, in the presence of a drive mass oscillation, an oscillation on the sensing mass 13, which is superimposed on the natural quadrature movement of the sensing mass. The resulting oscillation of the sensing mass 13 is in a direction perpendicular to the drive axis and the rotation axis.

However, when the gyroscope experiences an angular rotation rate, the quadrature induced movement of the sense mass and the Coriolis force induced movement of the sense mass are combined into the movement of the sensing mass 13. This total movement perturbs the capacitances Css1 and Css2. These changes in capacitance are detected by the sense readout circuitry 40 as a differential sense signal, Soutp and Soutn.

In MEMS gyroscope system 5 of Figure 1, the sense readout circuitry 40 includes a charge amplifier, which converts the capacitance changes into a voltage signal, followed by a demodulator that extracts the amplitude and phase information of the Coriolis-induced oscillation. The demodulator removes the drive oscillation component, leaving the Coriolis-induced signal, which is then used to indicate the angular rotation rate.

The sense readout circuitry 40 processes the differential sense signal Soutp and Soutn to determine the angular rate AR. This processing may involve amplification, demodulation, filtering, and digitization of the sense signal. The resulting digital signal is then scaled and calibrated to provide an output that represents the measured angular rate in a desired format (e.g., degrees per second or radians per second).

The MEMS gyroscope 10 is designed to operate in an inverted mismatch condition, where the resonance frequency of the driving mass 12 is intentionally set to be higher than the resonance frequency of the sensing mass 13.

Operating in an inverted mismatch condition offers better stability against aging and soldering. However, a concern arises during power-down events or power supply interruptions. When the rotor voltage RV, applied to the driving mass 12 through the rotor pad 50, drops during a power-down event or power supply interruption, the sense frame total stiffness increases. This raises the sense resonance frequency while the drive frequency remains unchanged, potentially leading to a mode-matched condition where the sense and drive resonance frequencies align and the mechanical output of the sense frame is maximized. As explained, in this condition of maximized mechanical output of the sense frame, if the oscillation amplitude of the driving mass does not diminish quickly enough, the residual movement, together with any inherent quadrature error, may prompt excessive oscillation of the sensing mass. This might be enough to make the sensing mass strike the internal mechanical stops, or bumpers, leading to potential damage or reliability concerns. Such collisions can release debris, forming conductive paths that risk electrical shorts between the rotor and stator.

Generation of the rotor voltage RV is now described together with a description of the circuitry utilized to avoid a mode-matched condition.

A charge pump 23, powered between the supply voltage VDD and ground, generates a charge pump output signal Cpout, which is selectively coupled to the rotor pad 50 by a high-voltage switch SW. The rotor voltage RV is formed across a decoupling capacitor Cdecouple connected between the rotor pad 50 and ground. The decoupling capacitor Cdecouple may be a discrete or integrated capacitor. In another solution, the decoupling capacitor Cdecouple may be a parasitic capacitance.

The switch SW is controlled by a control signal Ctrl generated by control circuitry 30, after passage through an AND gate 51. The control circuitry 30 includes a voltage ladder formed by resistors R1 and R2 series connected between the supply voltage VDD and ground, with a divided version of VDD, labeled as VDDdiv, formed at the tap N1 between R1 and R2. A comparator 31 receives VDDdiv at its non-inverting input and receives a bandgap voltage VBG generated by a bandgap generator 32 at its inverting input.

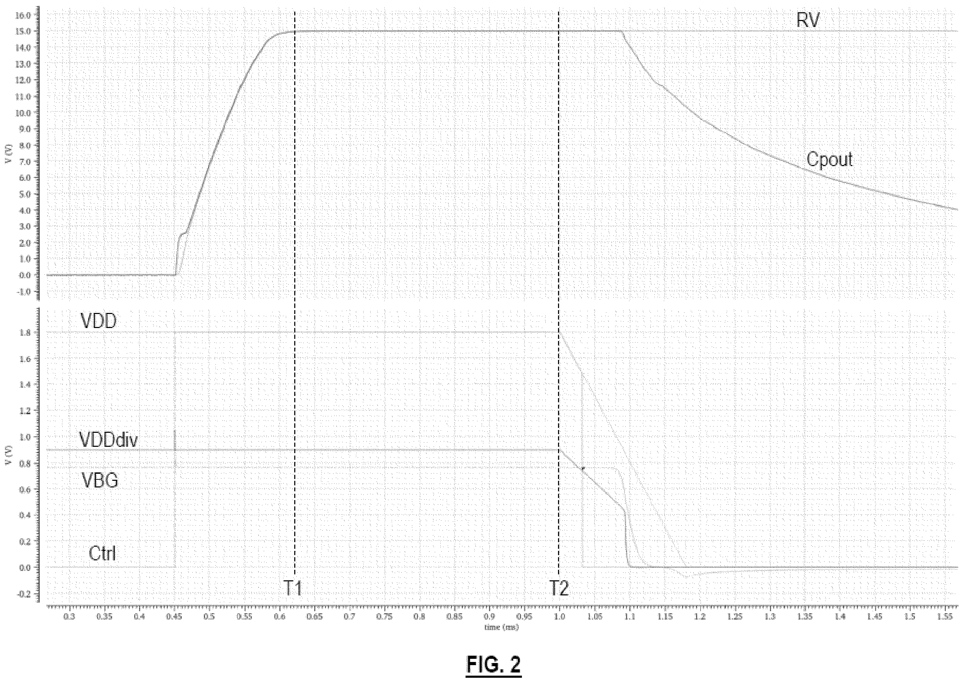

Operation during a power supply interruption event is now described with additional reference to FIG. 2.

During normal operation, between times T1 and T2, the supply voltage VDD remains stable, and as such, VDDdiv remains stable. Since in this condition VDDdiv will be greater than VBG, the comparator 31 maintains the control signal Ctrl asserted at its output, maintaining switch SW as being closed so that the charge pump 23 is connected to the rotor pad 50 to maintain the rotor voltage RV across the decoupling capacitor Cdecouple as being equal to Cpout.

At time T2, however, a power supply interruption event occurs. As a result, VDD, and therefore VDDdiv, begins to drop. Once VDDdiv falls below VBG, the comparator 31 deasserts the control signal Ctrl at its output, opening the switch SW. As a result, even though the charge pump output signal Cpout begins to fall, the rotor voltage RV across the decoupling capacitor Cdecouple remains constant, while the differential driving signals Drive_Forcing_P and Drive_Forcing_N decay due to the power supply interruption. Clearly, there will be some decay of RV over time, although this is not illustrated in FIGS. 2-3 due to the selected time scale.

When the rotor voltage RV is maintained at a constant level while the differential driving signals Drive_Forcing_P and Drive_Forcing_N decay, the MEMS gyroscope 10 avoids the mode-matched condition. The drive resonance frequency, as it is primarily determined by the physical properties of the driving mass 12 and its suspension system 14, as well as the electrostatic stiffness influenced by the rotor voltage RV, remains relatively stable. As the differential driving signals Drive_Forcing_P and Drive_Forcing_N decay, the oscillation amplitude of the driving mass 12 decreases due to the reduced driving force. However, as stated, the constant rotor voltage RV preserves the electrostatic stiffness and, consequently, maintains the sense resonance frequency as relatively constant. By keeping the sense resonance frequency lower than the drive resonance frequency, the inverted mismatch condition is sustained, avoiding a mode-matched condition where the drive and sense resonance frequencies align. In other words, a condition is avoided where resonance frequencies of the driving mass and the sensing mass become within a threshold value of each other.

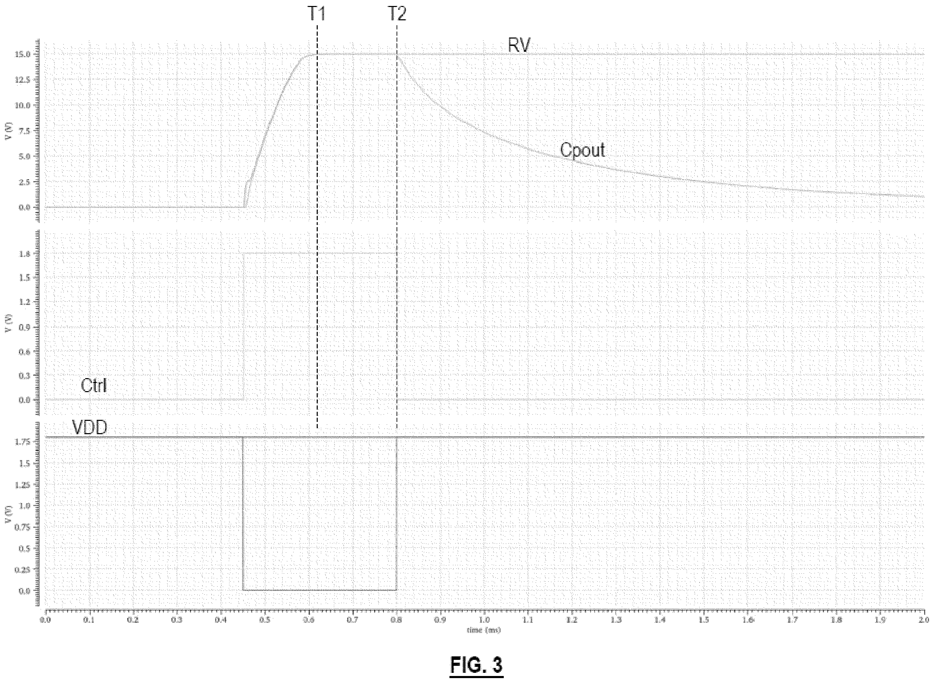

Operation during a power-down event is now described with reference to FIG. 3.

During normal operation, between times T1 and T2, the supply voltage VDD remains stable, and as such, VDDdiv remains stable. Since in this condition VDDdiv will be greater than VBG, the comparator 31 maintains the control signal Ctrl asserted at its output, maintaining switch SW as being closed so that the charge pump 23 is connected to the rotor pad 50 to maintain the rotor voltage RV across the decoupling capacitor Cdecouple as being equal to Cpout.

At time T2, however, the power-down event occurs (that is when the system is to be shut down via a received power down command Power_Dn) without removing the power supply. The power down command Power_Dn, received by the AND gate 51 at an inverting input thereof, causes the AND gate 51 to open the switch SW.

The described MEMS gyroscope system 5 offers several advantages over the prior art. By enabling the MEMS gyroscope 10 to operate in an inverted mismatch condition, where the resonance frequency of the driving mass 12 is intentionally set higher than the resonance frequency of the sensing mass 13, the device sensitivity can be enhanced while further reducing noise. This is particularly beneficial in highly miniaturized MEMS gyroscopes, in which the total sensitivity is to be enhanced, in the presence of small sensing electrodes, by reducing the frequency mismatch.

Moreover, the disclosed circuitry eliminates the need to wait for a certain amount of time before power-down of the gyroscope 10, regardless of the magnitude of the drive movement. This is achieved - as explained - by maintaining the rotor voltage RV constant during a power supply interruption event. The disclosed circuitry is effective not only when the device is shut down through a power-down command, but also when the supply voltage VDD is simply removed from the device.

As explained, by maintaining the rotor voltage RV constant, the mode-matched condition is avoided even when the power supply VDD is suddenly removed from the device.

As also explained, this is accomplished by the control circuitry 30, which opens the switch SW when the divided supply voltage VDDdiv falls below the bandgap voltage VBG during a power supply interruption event, and as a result, the rotor voltage RV across the decoupling capacitor Cdecouple remains constant, preserving the electrostatic stiffness and maintaining the sense resonance frequency as relatively constant to sustains the inverted mismatch condition, preventing a mode-matched condition where the drive and sense resonance frequencies align (or substantially align, or are within a certain threshold value or percentage of each other).

Consequently, the disclosed circuitry significantly reduces, or even eliminates, mechanical degradation of the MEMS gyroscope 10. By avoiding the mode-matched condition during power supply interruption events, the risk of the sensing mass 13 striking the internal mechanical stops or bumpers is minimized, preventing potential damage, reliability concerns, and the release of debris that could cause electrical shorts between the rotor and stators.

Finally, it is evident that modifications and variations can be made to what has been described and illustrated herein without departing from the scope of the present invention, as defined in the attached claims.

## Claims

1. A MEMS gyroscope system, comprising:
a micro-electromechanical gyroscope (10) comprising a driving mass (12) flexibly mechanically coupled to a sensing mass (13), and stators (12a-12d, 13a,13b) that remain static with respect to the driving mass (12) and the sensing mass (13);
driving circuitry (20) configured to apply a time-varying forcing signal (Drive_Forcing_P, Drive_Forcing_N) to the driving mass (12) through at least one capacitive coupling thereto;
a charge pump (23) powered by a supply voltage (VDD) and configured to generate a charge pump output signal (Cpout);
a decoupling capacitance (Cdecouple) directly electrically connected to a rotor pad (50);
detecting circuitry (30) configured to assert a control signal (Ctrl) when the supply voltage (VDD) is greater than a threshold voltage, but to deassert the control signal (Ctrl) when the supply voltage (VDD) is less than the threshold voltage; and
switch circuitry (SW) configured to couple the charge pump output signal (Cpout) to the decoupling capacitance (Cdecouple) so that a DC bias voltage (RV) is formed across the decoupling capacitance (Cdecouple) when the control signal (Ctrl) is asserted, but to decouple the charge pump output signal (Cpout) from the decoupling capacitance (Cdecouple) when the control signal (Ctrl) is deasserted, such that the DC bias voltage (RV) remains constant when the time-varying forcing signal (Drive_Forcing_P, Drive_Forcing_N) decays due to reduction in the supply voltage (VDD).

2. The MEMS gyroscope system of claim 1, wherein the detecting circuitry (30) comprises:
a voltage divider configured to generate a divided version of the supply voltage (VDDdiv); and
a comparator (31) configured to compare the divided version of the supply voltage (VDDdiv) to a reference voltage (VBG) to generate the control signal (Ctrl) as being asserted when the divided version of the supply voltage (VDDdiv) is greater than the reference voltage (VBG) but to generate the control signal (Ctrl) as being deasserted when the divided version of the supply voltage (VDDdiv) is less than the reference voltage (VBG).

3. The MEMS gyroscope system of the preceding claim, wherein the reference voltage (VBG) is generated by a bandgap voltage generator (32).

4. The MEMS gyroscope system of any of the preceding claims,
wherein the stators (12a-12d, 13a,13b) include at least one signal sensing stator (13a; 13b) capacitively coupled to the sensing mass (13), wherein the capacitive coupling between the at least one signal sensing stator (13a; 13b) and the sensing mass (13) changes as the sensing mass oscillates due to a Coriolis force induced by an angular rotation rate experienced by the MEMS gyroscope (10); and
further comprising sense readout circuitry (40) configured to determine the angular rotation rate based on the changes in capacitive coupling between the at least one signal sensing stator (13a; 13b) and the sensing mass (13).

5. The MEMS gyroscope system of any of the preceding claims,
wherein the stators (12a-12d, 13a,13b) include first and second forcing stators (12b; 12a) capacitively coupled to the driving mass (12);
wherein the time-varying forcing signal (Drive_Forcing_P, Drive_Forcing_N) comprises first and second differential forcing signals (Drive_Forcing_N, Drive_Forcing_P) applied to the driving mass through the first and second forcing stators.

6. The MEMS gyroscope system of the preceding claim,
wherein the stators (12a-12d, 13a,13b) include feedback sensing stators (12c, 12d) capacitively coupled to the driving mass (12);
wherein the capacitive coupling between the feedback sensing stators (12c, 12d) and the driving mass (12) changes as the driving mass (12) oscillates;
wherein the driving circuitry (20) further comprises:
a charge sensitive circuit (24) configured to generate a feedback signal (CFBp, CFBn) based on changes in capacitive coupling between the feedback sensing stators (12c, 12d) and the driving mass (12); and
a phase-locked loop (21) configured to adjust frequency and phase of the first and second differential forcing signals (Drive_Forcing_N, Drive_Forcing_P) based on the feedback signal (CFBp, CFBn).

7. The MEMS gyroscope system of any of the preceding claims, wherein the decoupling capacitor (Cdecouple) is a parasitic capacitance between the rotor pad (50) and ground.

8. A method of operating a micro-electromechanical gyroscope (10), comprising:
applying a time-varying forcing signal (Drive_Forcing_N, Drive_Forcing_P) to a driving mass (12) of the MEMS gyroscope (10) through at least one capacitive coupling, wherein the driving mass (12) is flexibly mechanically coupled to a sensing mass (13), and stators (12-12d, 13a, 13b) remain static with respect to the driving mass (12) and the sensing mass (13);
generating a charge pump output signal (Cpout) using a charge pump (23) powered by a supply voltage (VDD);
asserting a control signal (Ctrl) when the supply voltage (VDD) is greater than a threshold voltage and the MEMS gyroscope (10) is set in a powered-on condition;
deasserting the control signal (Ctrl) when the supply voltage (VDD) is less than the threshold voltage or a power down command is sent to the system to turn it off;
coupling the charge pump output signal (Cpout) to a decoupling capacitance (Cdecouple) that is directly electrically connected to the driving mass (12) so that a DC bias voltage (RV) is formed across the decoupling capacitance (Cdecouple) when the control signal (Ctrl) is asserted; and
decoupling the charge pump output signal (Cpout) from the decoupling capacitance (Cdecouple) when the control signal (Ctrl) is deasserted.

9. The method of the preceding claim, wherein the DC bias voltage (RV) to remain constant when the time-varying forcing signal (Drive_Forcing_N, Drive_Forcing_P) decays following the decoupling of the charge pump output signal (Cpout) from the decoupling capacitance (Cdecouple) when the control signal (Ctrl) is deasserted and due to reduction in the supply voltage (VDD), thereby avoiding a condition where resonance frequencies of the driving mass (12) and the sensing mass (13) to become within a threshold value of each other.

10. The method of the preceding claim, wherein the remaining of the DC bias voltage (RV) constant while the time-varying forcing signal (Drive_Forcing_N, Drive_Forcing_P) decays preserves an electrostatic stiffness of the MEMS gyroscope (10), thereby maintaining the resonance frequency of the sensing mass (13) lower than the resonance frequency of the driving mass (12).

11. The method of any of claims 8-10, further comprising:
generating a divided version of the supply voltage (VDDdiv) using a voltage divider; and
comparing the divided version of the supply voltage (VDDdiv) to a reference voltage (VBG) using a comparator (31) to generate the control signal (Ctrl) as being asserted when the divided version of the supply voltage (VDDdiv) is greater than the reference voltage (VBG) but to generate the control signal (Ctrl) as being deasserted when the divided version of the supply voltage (VDDdiv) is less than the reference voltage (VBG).

12. The method of any of claims 8-11, further comprising:
detecting changes in capacitive coupling between at least one signal sensing stator (13a; 13b) and the sensing mass (13), wherein the capacitive coupling changes as the sensing mass (13) oscillates due to a Coriolis force induced by an angular rotation rate experienced by the MEMS gyroscope (10); and
determining the angular rotation rate based on the changes in capacitive coupling between the at least one signal sensing stator (13a; 13b) and the sensing mass (13).

13. The method of any of claims 8-12, wherein applying the time-varying forcing signal (Drive_Forcing_N, Drive_Forcing_P) comprises:
generating a single-ended forcing signal (Drive_Forcing) using a phase-locked loop (21);
generating a first differential forcing signal (Drive_Forcing_P) from the single-ended forcing signal (Drive_Forcing) using a non-inverting amplifier;
generating a second differential forcing signal (Drive_Forcing_N) from the single-ended forcing signal (Drive_Forcing) using an inverting amplifier, wherein the first and second differential forcing signals (Drive_Forcing_P,Drive_Forcing_N) are complementary signals with a same amplitude but opposite in phase; and
applying the first and second differential forcing signals (Drive_Forcing_P,Drive_Forcing_N) to the driving mass (12) through first and second forcing stators (12a, 12b) of the stators (12a-12d) that are capacitively coupled to the driving mass (12).

14. The method of the preceding claim, further comprising:
generating a feedback signal (CFBp, CFBn) based on changes in capacitive coupling between feedback sensing stators (12c, 12d) and the driving mass (12), wherein the capacitive coupling changes as the driving mass (12) oscillates; and
adjusting frequency and phase of the single-ended forcing signal (Drive_Forcing) based on the feedback signal using the phase-locked loop (21).

15. The method of any of claims 8-14, wherein the MEMS gyroscope (10) is driven in an inverted mismatch condition, where a resonance frequency of the driving mass (12) is higher than a resonance frequency of the sensing mass (13).

## Patentansprüche

1. MEMS-Gyroskopsystem, umfassend:
ein mikroelektromechanisches Gyroskop (10), das eine Treibermasse (12), die flexibel mechanisch mit einer Sensormasse (13) gekoppelt ist, und Statoren (12a-12d, 13a, 13b) umfasst, die in Bezug auf die Treibermasse (12) und die Sensormasse (13) statisch bleiben;
einen Treiberschaltkreis (20), der konfiguriert ist, um ein zeitlich variierendes Erzwingungssignal (Drive_Forcing_P, Drive_Forcing_N) durch mindestens eine kapazitive Kopplung hindurch an die Treibermasse (12) anzulegen;
eine Ladepumpe (23), die von einer Versorgungsspannung (VDD) gespeist wird und konfiguriert ist, um ein Ladepumpenausgangssignal (Cpout) zu erzeugen;
eine Entkopplungskapazität (Cdecouple), die direkt elektrisch mit einer Rotorbelag (50) verbunden ist;
einen Erfassungsschaltkreis (30), der konfiguriert ist, um ein Steuersignal (Ctrl) geltend zu machen, wenn die Versorgungsspannung (VDD) größer als eine Schwellenspannung ist, jedoch das Steuersignal (Ctrl) zu deaktivieren, wenn die Versorgungsspannung (VDD) kleiner als die Schwellenspannung ist; und
einen Schalterschaltkreis (SW), der konfiguriert ist, um das Ladepumpenausgangssignal (Cpout) mit der Entkopplungskapazität (Cdecouple) zu koppeln, wenn das Steuersignal (Ctrl) über die Entkopplungskapazität (Cdecouple) geltend gemacht wird, eine DC-Vorspannung (RV) gebildet wird, jedoch das Ladepumpenausgangssignal (Cpout), wenn das Steuersignal (Ctrl) deaktiviert wird, von der Entkopplungskapazität (Cdecouple) zu entkoppeln, sodass die DC-Vorspannung (RV) konstant bleibt, wenn das zeitlich variierende Erzwingungssignal (Drive_Forcing_P, Drive_Forcing_N) aufgrund einer Reduktion der Versorgungsspannung (VDD) abklingt.

2. MEMS-Gyroskopsystem nach Anspruch 1, wobei der Erfassungsschaltkreis (30) umfasst:
einen Spannungsteiler, der so eingerichtet ist, dass er eine geteilte Version der Versorgungsspannung (VDDdiv) erzeugt; und
einen Komparator (31), der so eingerichtet ist, dass er die geteilte Version der Versorgungsspannung (VDDdiv) mit einer Referenzspannung (VBG) vergleicht, um das Steuersignal (Ctrl) als durchgesetzt zu erzeugen, wenn die geteilte Version der Versorgungsspannung (VDDdiv) größer ist als die Referenzspannung (VBG), aber das Steuersignal (Ctrl) als zurückgesetzt erzeugt, wenn die geteilte Version der Versorgungsspannung (VDDdiv) kleiner ist als die Referenzspannung (VBG).

3. MEMS-Gyroskopsystem nach dem vorhergehenden Anspruch, wobei die Referenzspannung (VBG) durch einen Bandgap-Spannungsgenerator (32) erzeugt wird.

4. MEMS-Gyroskopsystem nach einem der vorstehenden Ansprüche,
wobei die Statoren (12a-12d, 13a, 13b) mindestens einen Signalsensorstator (13a; 13b) beinhalten, der kapazitiv mit der Sensormasse (13) gekoppelt ist, wobei sich die kapazitive Kopplung zwischen dem mindestens einen Signalsensorstator (13a; 13b) und der Sensormasse (13) ändert, wenn die Sensormasse aufgrund einer Coriolis-Kraft, die durch eine vom MEMS-Gyroskop (10) erfahrene Winkeldrehgeschwindigkeit induziert wird, oszilliert; und weiter umfassend einen Messausleseschaltkreis (40), der konfiguriert ist, um die Winkeldrehgeschwindigkeit basierend auf den Änderungen der kapazitiven Kopplung zwischen dem mindestens einen Signalsensorstator (13a; 13b) und der Sensormasse (13) zu bestimmen.

5. MEMS-Gyroskopsystem nach einem der vorstehenden Ansprüche,
wobei die Statoren (12a-12d, 13a, 13b) erste und zweite Erzwingungsstatoren (12b; 12a) beinhalten, die kapazitiv mit der Treibermasse (12) gekoppelt sind;
wobei das zeitlich variierende Erzwingungssignal (Drive_Forcing_P, Drive_Forcing_N) erste und zweite differenzielle Erzwingungssignale (Drive_Forcing_N, Drive_Forcing_P) umfasst, die durch den ersten und zweiten Erzwingungsstator an die Treibermasse angelegt werden.

6. MEMS-Gyroskopsystem nach dem vorstehenden Anspruch,
wobei die Statoren (12a-12d, 13a, 13b) Rückkopplungssensorstatoren (12c, 12d) beinhalten, die kapazitiv mit der Treibermasse (12) gekoppelt sind;
wobei sich die kapazitive Kopplung zwischen den Rückkopplungssensorstatoren (12c, 12d) und der Treibermasse (12) ändert, wenn die Treibermasse (12) oszilliert;
wobei der Treiberschaltkreis (20) weiter umfasst:
eine ladungsempfindliche Schaltung (24), die konfiguriert ist, um ein Rückkopplungssignal (CFBp, CFBn) basierend auf Änderungen der kapazitiven Kopplung zwischen den Rückkopplungssensorstatoren (12c, 12d) und der Treibermasse (12) zu erzeugen; und
eine phasenverriegelte Schleife (21), die konfiguriert ist, um Frequenz und Phase der ersten und zweiten differenziellen Erzwingungssignale (Drive_Forcing_N, Drive_Forcing_P) basierend auf dem Rückkopplungssignal (CFBp, CFBn) anzupassen.

7. MEMS-Gyroskopsystem nach einem der vorstehenden Ansprüche, wobei der Entkopplungskondensator (Cdecouple) eine parasitäre Kapazität zwischen dem Rotorbelag (50) und Masse ist.

8. Verfahren zum Bedienen eines mikroelektromechanischen Gyroskops (10), umfassend:
Anlegen eines zeitlich variierenden Erzwingungssignals (Drive_Forcing_N, Drive_Forcing_P) an eine Treibermasse (12) des MEMS-Gyroskops (10) durch mindestens eine kapazitive Kopplung, wobei die Treibermasse (12) flexibel mechanisch mit einer Sensormasse (13) gekoppelt ist, und Statoren (12-12d, 13a, 13b) in Bezug auf die Treibermasse (12) und die Sensormasse (13) statisch bleiben;
Erzeugen eines Ladepumpenausgangssignals (Cpout) unter Verwendung einer von einer Versorgungsspannung (VDD) gespeisten Ladepumpe (23);
Geltend machen eines Steuersignals (Ctrl), wenn die Versorgungsspannung (VDD) größer ist als eine Schwellenspannung und das MEMS-Gyroskop (10) in einen eingeschalteten Zustand gesetzt wird;
Deaktivieren des Steuersignals (Ctrl), wenn die Versorgungsspannung (VDD) geringer als die Schwellenspannung ist oder ein Abschaltbefehl an das System gesendet wird, um es auszuschalten;
Koppeln des Ladepumpenausgangssignals (Cpout) an eine Entkopplungskapazität (Cdecouple), die direkt elektrisch mit der Treibermasse (12) verbunden ist, sodass eine DC-Vorspannung (RV) über die Entkopplungskapazität (Cdecouple) gebildet wird, wenn das Steuersignal (Ctrl) geltend gemacht wird; und
Entkoppeln des Ladepumpenausgangssignals (Cpout) von der Entkopplungskapazität (Cdecouple), wenn das Steuersignal (Ctrl) deaktiviert wird.

9. Verfahren nach dem vorstehenden Anspruch, wobei die DC-Vorspannung (RV) konstant bleibt, wenn das zeitlich variierende Erzwingungssignal (Drive_Forcing_N, Drive_Forcing_P) infolge des Entkoppelns des Ladepumpenausgangssignals (Cpout) von der Entkopplungskapazität (Cdecouple), wenn das Steuersignal (Ctrl) deaktiviert wird, und aufgrund des Reduzierens der Versorgungsspannung (VDD) abklingt, wodurch ein Zustand vermieden wird, in dem die Resonanzfrequenzen der Treibermasse (12) und der Sensormasse (13) innerhalb eines Schwellenwerts voneinander liegen.

10. Verfahren nach dem vorstehenden Anspruch, wobei das konstant bleiben der DC-Vorspannung (RV), während das zeitlich variierende Erzwingungssignal (Drive_Forcing_N, Drive_Forcing_P) abklingt, eine elektrostatische Steifigkeit des MEMS-Gyroskops (10) aufrecht erhält, wodurch die Resonanzfrequenz der Sensormasse (13) niedriger bleibt als die Resonanzfrequenz der Treibermasse (12).

11. Verfahren nach einem der Ansprüche 8 bis 10, das ferner Folgendes umfasst:
Erzeugen einer geteilten Version der Versorgungsspannung (VDDdiv) mithilfe eines Spannungsteilers; und
Vergleichen der geteilten Version der Versorgungsspannung (VDDdiv) mit einer Referenzspannung (VBG) unter Verwendung eines Komparators (31) zum Erzeugen des Steuersignals (Ctrl) als durchgesetzt, wenn die geteilte Version der Versorgungsspannung (VDDdiv) größer ist als die Referenzspannung (VBG), aber zum Erzeugen des Steuersignals (Ctrl) als zurückgesetzt, wenn die geteilte Version der Versorgungsspannung (VDDdiv) kleiner ist als die Referenzspannung (VBG).

12. Verfahren nach einem der Ansprüche 8 bis 11, das ferner Folgendes umfasst:
Erkennen von Änderungen der kapazitiven Kopplung zwischen mindestens einem Signalsensorstator (13a; 13b) und der Sensormasse (13), wobei sich die kapazitive Kopplung ändert, wenn die Sensormasse (13) aufgrund einer Coriolis-Kraft, die durch eine vom MEMS-Gyroskop (10) erfahrene Winkeldrehgeschwindigkeit induziert wird, oszilliert; und
Bestimmen der Winkeldrehgeschwindigkeit basierend auf den Änderungen der kapazitiven Kopplung zwischen dem mindestens einen Signalsensorstator (13a; 13b) und der Sensormasse (13).

13. Verfahren nach einem der Ansprüche 8-12, wobei Anwenden des zeitlich variierenden Erzwingungssignals (Drive_Forcing_N, Drive_Forcing_P) umfasst:
Erzeugen eines einseitigen Erzwingungssignals (Drive_Forcing) unter Verwendung einer phasenverriegelten Schleife (21);
Erzeugen eines ersten differenziellen Erzwingungssignals (Drive_Forcing_P) aus dem einseitigen Erzwingungssignal (Drive_Forcing) unter Verwendung eines nichtinvertierenden Verstärkers;
Erzeugen eines zweiten differenziellen Erzwingungssignals (Drive_Forcing_N) aus dem einseitigen Erzwingungssignal (Drive_Forcing) unter Verwendung eines invertierenden Verstärkers, wobei das erste und zweite differenzielle Erzwingungssignal (Drive_Forcing_P,Drive_Forcing_N) komplementäre Signale mit einer gleichen Amplitude, aber gegenphasig sind; und
Anlegen des ersten und zweiten differenziellen Erzwingungssignals (Drive_Forcing_P,Drive_Forcing_N) an die Treibermasse (12) durch erste und zweite Erzwingungsstatoren (12a, 12b) der Statoren (12a-12d), die kapazitiv mit der Treibermasse (12) gekoppelt sind.

14. Verfahren nach dem vorstehenden Anspruch, weiter umfassend:
Erzeugen eines Rückkopplungssignals (CFBp, CFBn) basierend auf Änderungen der kapazitiven Kopplung zwischen den Rückkopplungssensorstatoren (12c, 12d) und der Treibermasse (12), wobei sich die kapazitive Kopplung ändert, wenn die Treibermasse (12) oszilliert; und
Anpassen von Frequenz und Phase des einseitigen Erzwingungssignals (Drive_Forcing) basierend auf Rückkopplungssignal unter Verwendung der phasenverriegelten Schleife (21).

15. Verfahren nach einem der Ansprüche 8-14, wobei das MEMS-Gyroskop (10) in einer invertierten Fehlanpassungsbedingung betrieben wird, wobei eine Resonanzfrequenz der Treibermasse (12) höher ist als eine Resonanzfrequenz der Sensormasse (13).

## Revendications

1. Système de gyroscope MEMS comprenant :
un gyroscope micro-électromécanique (10) comprenant une masse d'entraînement (12) accouplée mécaniquement de façon souple à une masse de mesure (13), et des stators (12a-12d, 13a, 13b) qui restent immobiles par rapport à la masse d'entraînement (12) et à la masse de mesure (13) ;
un montage de pilotage (20) configuré pour appliquer un signal de forçage variant dans le temps (Drive_Forcing_P, Drive_Forcing_N) à la masse d'entraînement (12) via au moins un couplage capacitif avec celle-ci ;
une pompe de charge (23) alimentée par une tension d'alimentation (VDD) et configurée pour produire un signal de sortie de pompe de charge (Cpout) ;
une capacité de découplage (Cdecouple) directement reliée électriquement à un plot de rotor (50) ;
un montage de détection (30) configuré pour activer un signal de commande (Ctrl) quand la tension d'alimentation (VDD) est supérieure à une tension de seuil, mais pour désactiver le signal de commande (Ctrl) quand la tension d'alimentation (VDD) est inférieure à la tension de seuil ; et
un montage d'interrupteur (SW) configuré pour coupler le signal de sortie de pompe de charge (Cpout) à la capacité de découplage (Cdecouple) de sorte qu'une tension de polarisation continue (RV) est formée aux bornes de la capacité de découplage (Cdecouple) quand le signal de commande (Ctrl) est activé, mais pour découpler le signal de sortie de pompe de charge (Cpout) de la capacité de découplage (Cdecouple) quand le signal de commande (Ctrl) est désactivé, de telle manière que la tension de polarisation continue (RV) reste constante quand le signal de forçage variant dans le temps (Drive_Forcing_P, Drive_Forcing_N) décroît en raison de la réduction de la tension d'alimentation (VDD).

2. Système de gyroscope MEMS selon la revendication 1, dans lequel le montage de détection (30) comprend :
un diviseur de tension configuré pour produire une version divisée de la tension d'alimentation (VDDdiv) ; et
un comparateur (31) configuré pour comparer la version divisée de la tension d'alimentation (VDDdiv) avec une tension de référence (VBG) pour produire le signal de commande (Ctrl) en tant que signal activé quand la version divisée de la tension d'alimentation (VDDdiv) est supérieure à la tension de référence (VBG) mais pour produire le signal de commande (Ctrl) en tant que signal désactivé quand la version divisée de la tension d'alimentation (VDDdiv) est inférieure à la tension de référence (VBG).

3. Système de gyroscope MEMS selon la revendication précédente, dans lequel la tension de référence (VBG) est produite par un générateur de tension à bande interdite (32).

4. Système de gyroscope MEMS selon l'une quelconque des revendications précédentes,
dans lequel les stators (12a-12d, 13a, 13b) comprennent au moins un stator de mesure de signal (13a ; 13b) couplé de façon capacitive à la masse de mesure (13), dans lequel le couplage capacitif entre ledit au moins un stator de mesure de signal (13a ; 13b) et la masse de mesure (13) varie lorsque la masse de mesure oscille en raison d'une force de Coriolis induite par une vitesse de rotation angulaire subie par le gyroscope MEMS (10) ; et
comprenant en outre un montage de relevé de mesure (40) configuré pour déterminer la vitesse de rotation angulaire d'après les variations de couplage capacitif entre ledit au moins un stator de mesure de signal (13a ; 13b) et la masse de mesure (13).

5. Système de gyroscope MEMS selon l'une quelconque des revendications précédentes,
dans lequel les stators (12a-12d, 13a, 13b) comprennent des premier et deuxième stators de forçage (12b ; 12a) couplés de façon capacitive à la masse d'entraînement (12) ;
dans lequel le signal de forçage variant dans le temps (Drive_Forcing_P, Drive_Forcing_N) comprend des premier et deuxième signaux de forçage différentiels (Drive_Forcing_N, Drive_Forcing_P) appliqués à la masse d'entraînement par l'intermédiaire des premier et deuxième stators de forçage.

6. Système de gyroscope MEMS selon la revendication précédente,
dans lequel les stators (12a-12d, 13a, 13b) comprennent des stators de mesure de rétroaction (12c, 12d) couplés de façon capacitive à la masse d'entraînement (12) ;
dans lequel le couplage capacitif entre les stators de mesure de rétroaction (12c, 12d) et la masse d'entraînement (12) varie lorsque la masse d'entraînement (12) oscille ;
dans lequel le montage de pilotage (20) comprend en outre :
un circuit sensible à la charge (24) configuré pour produire un signal de rétroaction (CFBp, CFBn) basé sur les variations de couplage capacitif entre les stators de mesure de rétroaction (12c, 12d) et la masse d'entraînement (12) ; et
une boucle à verrouillage de phase (21) configurée pour ajuster la fréquence et la phase des premier et deuxième signaux de forçage différentiels (Drive_Forcing_N, Drive_Forcing_P) d'après le signal de rétroaction (CFBp, CFBn).

7. Système de gyroscope MEMS selon l'une quelconque des revendications précédentes, dans lequel la capacité de découplage (Cdecouple) est une capacité parasite entre le plot de rotor (50) et la masse.

8. Procédé de mise en œuvre d'un gyroscope micro-électromécanique (10), comprenant les étapes suivantes :
appliquer un signal de forçage variant dans le temps (Drive_Forcing_N, Drive_Forcing_P) à une masse d'entraînement (12) du gyroscope MEMS (10) via au moins un couplage capacitif, dans lequel la masse d'entraînement (12) est accouplée mécaniquement de façon souple à une masse de mesure (13), et des stators (12-12d, 13a, 13b) restent immobiles par rapport à la masse d'entraînement (12) et à la masse de mesure (13) ;
produire un signal de sortie de pompe de charge (Cpout) en utilisant une pompe de charge (23) alimentée par une tension d'alimentation (VDD) ;
activer un signal de commande (Ctrl) quand la tension d'alimentation (VDD) est supérieure à une tension de seuil et que le gyroscope MEMS (10) est mis dans un état alimenté ;
désactiver le signal de commande (Ctrl) quand la tension d'alimentation (VDD) est inférieure à la tension de seuil ou quand une instruction de mise hors tension est envoyée au système pour l'éteindre ;
coupler le signal de sortie de pompe de charge (Cpout) à une capacité de découplage (Cdecouple) qui est directement reliée électriquement à la masse d'entraînement (12) de sorte qu'une tension de polarisation continue (RV) est formée aux bornes de la capacité de découplage (Cdecouple) quand le signal de commande (Ctrl) est activé ; et
découpler le signal de sortie de pompe de charge (Cpout) de la capacité de découplage (Cdecouple) quand le signal de commande (Ctrl) est désactivé.

9. Procédé selon la revendication précédente, dans lequel la tension de polarisation continue (RV) reste constante quand le signal de forçage variant dans le temps (Drive_Forcing_N, Drive_Forcing_P) décroît suite au découplage du signal de sortie de pompe de charge (Cpout) de la capacité de découplage (Cdecouple) quand le signal de commande (Ctrl) est désactivé et en raison de la réduction de la tension d'alimentation (VDD), évitant ainsi un état dans lequel les fréquences de résonnance de la masse d'entraînement (12) et de la masse de mesure (13) se trouvent dans une valeur de seuil l'une par rapport à l'autre.

10. Procédé selon la revendication précédente, dans lequel le maintien à une valeur constante de la tension de polarisation continue (RV) pendant que le signal de forçage variant dans le temps (Drive_Forcing_N, Drive_Forcing_P) décroît préserve une rigidité électrostatique du gyroscope MEMS (10), maintenant ainsi la fréquence de résonnance de la masse de mesure (13) inférieure à la fréquence de résonnance de la masse d'entraînement (12).

11. Procédé selon l'une quelconque des revendications 8 à 10, comprenant en outre les étapes suivantes :
produire une version divisée de la tension d'alimentation (VDDdiv) en utilisant un diviseur de tension ; et
comparer la version divisée de la tension d'alimentation (VDDdiv) avec une tension de référence (VBG) en utilisant un comparateur (31) pour produire le signal de commande (Ctrl) en tant que signal activé quand la version divisée de la tension d'alimentation (VDDdiv) est supérieure à la tension de référence (VBG) mais pour produire le signal de commande (Ctrl) en tant que signal désactivé quand la version divisée de la tension d'alimentation (VDDdiv) est inférieure à la tension de référence (VBG).

12. Procédé selon l'une quelconque des revendications 8 à 11, comprenant en outre les étapes suivantes :
détecter les variations de couplage capacitif entre au moins un stator de mesure de signal (13a ; 13b) et la masse de mesure (13), dans lequel le couplage capacitif varie lorsque la masse de mesure (13) oscille en raison d'une force de Coriolis induite par une vitesse de rotation angulaire subie par le gyroscope MEMS (10) ; et
déterminer la vitesse de rotation angulaire d'après les variations de couplage capacitif entre ledit au moins un stator de mesure de signal (13a ; 13b) et la masse de mesure (13).

13. Procédé selon l'une quelconque des revendications 8 à 12, dans lequel l'application du signal de forçage variant dans le temps (Drive_Forcing_N, Drive_Forcing_P) comprend les étapes suivantes :
produire un signal de forçage à sortie unique (Drive_Forcing) en utilisant une boucle à verrouillage de phase (21) ;
produire un premier signal de forçage différentiel (Drive_Forcing_P) à partir du signal de forçage à sortie unique (Drive_Forcing) en utilisant un amplificateur non inverseur ;
produire un deuxième signal de forçage différentiel (Drive_Forcing_N) à partir du signal de forçage à sortie unique (Drive_Forcing) en utilisant un amplificateur inverseur, dans lequel les premier et deuxième signaux de forçage différentiel (Drive_Forcing_P, Drive_Forcing_N) sont des signaux complémentaires de même amplitude mais de phase contraire ; et
appliquer les premier et deuxième signaux de forçage différentiel (Drive_Forcing_P, Drive_Forcing_N) à la masse d'entraînement (12) par l'intermédiaire de premier et deuxième stators de forçage (12a, 12b) des stators (12a-12d) qui sont couplés de façon capacitive à la masse d'entraînement (12).

14. Procédé selon la revendication précédente, comprenant en outre les étapes suivantes :
produire un signal de rétroaction (CFBp, CFBn) basé sur les variations de couplage capacitif entre les stators de mesure de rétroaction (12c, 12d) et la masse d'entraînement (12), le couplage capacitif variant lorsque la masse d'entraînement (12) oscille ; et
ajuster la fréquence et la phase du signal de forçage à sortie unique (Drive_Forcing) d'après le signal de rétroaction en utilisant la boucle à verrouillage de phase (21).

15. Procédé selon l'une quelconque des revendications 8 à 14, dans lequel le gyroscope MEMS (10) est piloté dans un état de désaccord inversé, où une fréquence de résonnance de la masse d'entraînement (12) est supérieure à une fréquence de résonnance de la masse de mesure (13).
